# EUROPEAN PATENT APPLICATION

(11) **EP 2 388 828 A1**
(43) Date of publication of application: **23.11.2011**
(21) Application number: 10731263.9
(22) Date of filing: 14.01.2010
(51) Int. Cl.: H01L 31/042

(54) **SOLAR CELL MODULE AND METHOD FOR MANUFACTURING SOLAR CELL MODULE**

(30) Priority: 16.01.2009 JP 2009007885; 26.01.2009 JP 2009014257
(71) Applicant: Sharp Kabushiki Kaisha, Osaka-shi, Osaka 545-8522 (JP)
(72) Inventor: SAINOO, Yasushi, Osaka-shi, Osaka 545-8522 (JP); NISHINA, Tomohiro, Osaka-shi, Osaka 545-8522 (JP); IMATAKI, Tomoo, Osaka-shi, Osaka 545-8522 (JP); SHIRAKI, Tomoyo, Osaka-shi, Osaka 545-8522 (JP); TSUNEMI, Akiko, Osaka-shi, Osaka 545-8522 (JP); MIKAMI, Rui, Osaka-shi, Osaka 545-8522 (JP); ABIKO, Yoshiya, Osaka-shi, Osaka 545-8522 (JP)
(74) Representative: Müller - Hoffmann & Partner
(86) International application number: PCT/JP2010/050312
(87) International publication number: WO 2010/082594

(57) **Abstract**

A solar cell module and a method for manufacturing a solar cell module are provided. The solar cell module includes an interconnect sheet (10) and a back contact solar cell (20) mounted on the interconnect sheet (10). Electrodes (24, 25) of the back contact solar cell (20) and interconnects (12, 13) of the interconnect sheet (10) are connected to each other. An electrically insulating cured resin (17) is disposed in a region between interconnects (12, 13) adjacent to each other of the interconnect sheet (10), the region being located between a semiconductor substrate (21) of the back contact solar cell (20) and an insulating base material (11) of the interconnect sheet (10).

## Description

### TECHNICAL FIELD

The present invention relates to a solar cell module and a method for manufacturing a solar cell module.

### BACKGROUND ART

In recent years, because of global environmental problems such as the problem of energy resource exhaustion and the increase of CO₂ in the atmosphere, development of clean energies has been expected. In particular, as a new energy source, solar photovoltaic power generation by means of a solar cell module has been developed and brought into practical use and is following the path of development.

As solar cells constituting such a solar cell module, double-sided-contact solar cells have conventionally been in the mainstream. For example, in the double-sided-contact solar cell, a pn junction is formed by diffusing, in a light receiving surface of a single-crystalline or polycrystalline silicon substrate, an impurity of a conductivity type opposite to the silicon substrate, and electrodes are formed respectively on the light receiving surface of the silicon substrate and its opposite back surface. In these years, development is also being promoted of a so-called back contact solar cell having an electrode for the p type and an electrode for the n type that are both formed on the back surface of a silicon substrate.

For example, U.S. Patent No. 5,951,786 (Patent Literature 1) discloses a solar cell module in which electrically conductive interconnects are patterned on a surface of an insulating base material, and back contact solar cells are electrically connected onto the interconnects.

### CITATION LIST

### PATENT LITERATURE

PTL 1: U.S. Patent No. 5,951,786

### SUMMARY OF INVENTION

### TECHNICAL PROBLEM

A solar cell module configured as disclosed in above-referenced Patent Literature 1 may be fabricated for example in the following way.

First, on a surface of a mesh-shaped insulating base material made of a polymer material for example, patterned interconnects are formed.

Next, to the interconnects patterned on the surface of the mesh-shaped insulating base material, electrodes of the back contact solar cells are joined with an electrically conductive adhesive to thereby electrically connect the back contact solar cells to the interconnects on the surface of the mesh-shaped insulating base material.

Then, the back contact solar cells electrically connected to the interconnects on the surface of the mesh-shaped insulating base material are heat-treated while being pressure-joined to an encapsulant material applied between a glass substrate and the back contact solar cells and between a protective back sheet and the back contact solar cells so as to encapsulate the back contact solar cells in the encapsulant material. In this way, a solar cell module is fabricated.

Here, the encapsulant material flows through openings of the mesh-shaped insulating base material to the space between the back contact solar cells and interconnects, and is cured therein to thereby encapsulate the back contact solar cells between the glass substrate and the protective back sheet (see Patent Literature 1, column 7, lines 13 to 28).

Regarding the solar cell module disclosed in Patent Literature 1, the presence of a space between the back contact solar cells and the insulating base material causes a problem of reliability. Therefore, the insulating base material is formed in the shape of a mesh, a sheet-like encapsulant material is provided on the insulating base material, and heated and pressure-joined thereto to thereby fill the space between the back contact solar cells and the insulating base material.

Such an encapsulant material, however, may not be able to sufficiently fill the space between the back contact solar cells and the insulating base material, or may not be able to ensure a sufficient joint strength between the back contact solar cells and the insulating base material, for example, which may cause a connection failure between the electrodes on the back contact solar cells and the interconnects on the insulating base material. If such a connection failure or crack of the back contact solar cells occurs, heat could be generated locally. In particular, under a high temperature condition in an environment for use, the encapsulant material which fills the space between the back contact solar cells and the insulating base material may thermally expand to cause a stress in the direction of peeling away from each other the interconnects on the insulating base material and the electrodes of the back contact solar cells.

For the solar cell module disclosed in Patent Literature 1, what is only taken into consideration is the configuration in which opposite ends of the back contact solar cell are provided with respective electrodes. If a greater number of electrodes of the back contact solar cell and a greater number of interconnects for the electrodes are provided than those disclosed, the spaces between the electrodes and between interconnects are accordingly smaller, and the above-described problems are likely to be more significant.

In view of the circumstances above, an object of the present invention is to provide a solar cell module and a method for manufacturing a solar cell module that can achieve high reliability, by further strengthening the joint between the back contact solar cells and the insulating base material.

### SOLUTION TO PROBLEM

The present invention is a solar cell module including an interconnect sheet and a back contact solar cell mounted on the interconnect sheet. The interconnect sheet includes an insulating base material and interconnects mounted on the insulating base material. The back contact solar cell includes a semiconductor substrate and electrodes formed to be connected on one surface of the semiconductor substrate. The electrodes of the back contact solar cell and the interconnects of the interconnect sheet are connected to each other. An insulating cured resin is disposed in a region between the interconnects adjacent to each other of the interconnect sheet, the region being located between the semiconductor substrate of the back contact solar cell and the insulating base material of the interconnect sheet.

Preferably, in the solar cell module of the present invention, the cured resin is formed by curing a resin composition, and a thermal expansion force of the cured resin is smaller than a contraction force of the resin composition when cured. Here, the resin composition preferably contains at least one of an epoxy resin and an acrylic resin.

Preferably, in the solar cell module of the present invention, an adhesion strength of the cured resin of adhering the semiconductor substrate of the back contact solar cell and the insulating base material of the interconnect sheet is larger than the contraction force of the resin composition when cured. Here, the resin composition preferably contains at least one of an epoxy resin and an acrylic resin.

Preferably, in the solar cell module of the present invention, the cured resin is a cured resin which is cured in at least two stages.

Preferably, in the solar cell module of the present invention, a plurality of back contact solar cells are connected to the interconnect sheet.

Further, the present invention is a method for manufacturing a solar cell module, including the steps of: applying an insulating resin composition onto a surface of an interconnect sheet including an insulating base material and interconnects mounted on the insulating base material, the interconnects being mounted on the surface of the interconnect sheet, and/or onto one surface of a semiconductor substrate of a back contact solar cell including the semiconductor substrate and a plurality of electrodes formed to be connected on the one surface, the electrodes being formed on the one surface; superposing the interconnect sheet and the back contact solar cell on each other; and curing the resin composition to form an insulating cured resin in a region between the interconnects adjacent to each other of the interconnect sheet, the region being located between the semiconductor substrate of the back contact solar cell and the insulating base material of the interconnect sheet,.

According to the method for manufacturing a solar cell module of the present invention, preferably in the step of applying the resin composition, the resin composition is applied onto the surface on which the interconnects of the interconnect sheet are mounted, and in the step of superposing, the back contact solar cell is mounted on the interconnect sheet so that the electrodes of the back contact solar cell are located on the interconnects of the interconnect sheet. Here, more preferably, the interconnects of the interconnect sheet include a portion shaped to have a plurality of rectangles arranged in a direction orthogonal to a longitudinal direction of the rectangles, and in the step of applying the resin composition, the resin composition is applied in a direction substantially orthogonal to the longitudinal direction of the rectangles of the interconnects. Further, more preferably, the resin composition is converted to at least a B stage cure state and a C stage cure state. Here, still more preferably, in the step of superposing, the resin composition is in the B stage cure state.

According to the method for manufacturing a solar cell module of the present invention, preferably in the step of applying the resin composition, the resin composition is applied onto the surface on which the electrodes of the back contact solar cell are formed, and in the step of superposing, the interconnect sheet is mounted on the back contact solar cell so that the interconnects of the interconnect sheet are located on the electrodes of the back contact solar cell. Here, more preferably, the resin composition is converted to at least a B stage cure state and a C stage cure state. Further, still more preferably, in the step of superposing, the resin composition is in the B stage cure state.

### ADVANTAGEOUS EFFECTS OF INVENTION

The present invention is able to further strengthen the joint between the back contact solar cell and the insulating base material to thereby reduce a load exerted on the connection between the electrodes of the back contact solar cell and the interconnects of the interconnect sheet and accordingly improve the reliability.

### BRIEF DESCRIPTION OF DRAWINGS

Fig. 1(a) is a schematic plan view showing an example of an interconnect sheet used in a first embodiment, as seen from an interconnect-mounted-side, and Fig. 1(b) is a schematic cross section along 1b-1b in Fig. 1(a).
Fig. 2(a) is a schematic cross section of an example of a back contact solar cell to be electrically connected to an interconnect of the interconnect sheet used in the first embodiment, and Fig. 2(b) is a schematic plan view of an example of the back surface of a semiconductor substrate for the back contact solar cell shown in Fig. 2(a).
Fig. 3(a) is a schematic plan view of another example of the back surface of the semiconductor substrate for the back contact solar cell shown in Fig. 2(a), and Fig. 3(b) is a schematic plan view of still another example of the back surface of the semiconductor substrate for the back contact solar cell shown in Fig. 2(a).
Fig. 4(a) is a schematic plan view of an example of a solar cell module in the first embodiment, as seen from a light receiving surface side, and Fig. 4(b) is a schematic cross section along 4b-4b in Fig. 4(a).
Fig. 5(a) to Fig. 5(c) are each a schematic diagram illustrating an example of a method for manufacturing a solar cell module in the first embodiment.
Fig. 6(a) and Fig. 6(b) are each a schematic cross section illustrating an example of a manufacturing method to encapsulate an example of the solar cell module in the first embodiment.
Fig. 7(a) and Fig. 7(b) are each a schematic cross section illustrating another example of the manufacturing method to encapsulate an example of the solar cell module in the first embodiment.
Fig. 8(a) to Fig. 8(d) are each a schematic diagram illustrating an example of a method for manufacturing an example of a solar cell equipped with an interconnect sheet in the first embodiment.
Fig. 9(a) to Fig. 9(c) are each a schematic diagram illustrating an example of a method for manufacturing an example of a solar cell module in a second embodiment.
Fig. 10(a) to Fig. 10(d) are each a schematic diagram illustrating an example of a method for manufacturing an example of a solar cell equipped with an interconnect sheet in the second embodiment.
Fig. 11(a) to Fig. 11(f) are each a schematic cross section illustrating a manufacturing method to encapsulate a solar cell module in the second embodiment.

### DESCRIPTION OF EMBODIMENTS

In the following, embodiments of the present invention will be described. In the drawings for the present invention, the same reference characters denote the same or corresponding components.

### First Embodiment

### <Interconnect Sheet>

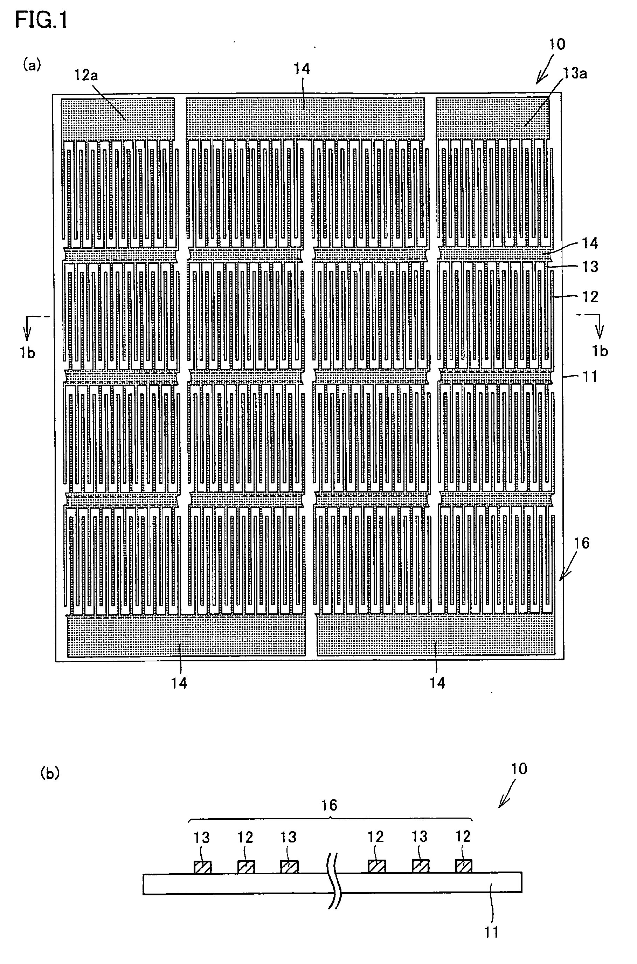

Fig. 1(a) shows a schematic plan view of an example of an interconnect sheet used in a first embodiment, as seen from an interconnect-mounted side. As shown in Fig. 1(a), an interconnect sheet 10 includes an insulating base material 11, and an interconnect 16 which includes an interconnect for the n-type referred to herein as n-type-adapted interconnect 12, an interconnect for the p-type referred to herein as p-type-adapted interconnect 13, and an interconnect for making connection referred to herein as connection-adapted interconnect 14.

Here, n-type-adapted interconnect 12, p-type-adapted interconnect 13, and connection-adapted interconnect 14 are each electrically conductive, and n-type-adapted interconnect 12 and p-type-adapted interconnect 13 are each comb-shaped and include a portion shaped to have a plurality of rectangles arranged along the direction orthogonal to the longitudinal direction of the rectangles. In contrast, connection-adapted interconnect 14 is strip-shaped. Further, except for an n-type-adapted interconnect 12a and a p-type-adapted interconnect 13b that are each located on an end of interconnect sheet 10, n-type-adapted interconnect 12 and p-type-adapted interconnect 13 adjacent to each other are electrically connected by connection-adapted interconnect 14.

On interconnect sheet 10, n-type-adapted interconnect 12 and p-type-adapted interconnect 13 are each arranged in such a manner that every single element corresponding to a comb tooth (rectangle) of comb-shaped n-type-adapted interconnect 12 and every single element corresponding to a comb tooth (rectangle) of comb-shaped p-type-adapted interconnect 13 interdigitate with each other. Accordingly, every single element corresponding to a comb tooth of comb-shaped n-type-adapted interconnect 12 and every single element corresponding to a comb tooth of comb-shaped p-type-adapted interconnect 13 are arranged alternately with a predetermined space therebetween. Alternatively, for at least one of the comb teeth elements of n-type-adapted interconnect 12 and the comb teeth elements of p-type-adapted interconnect 13, every multiple elements, rather than every single element, may be arranged alternately. In any case, one of n-type-adapted interconnect 12 and p-type-adapted interconnect 13 includes a portion where its interconnect element is located at least partially between interconnect elements of the other.

Fig. 1(b) shows a schematic cross section along 1b-1b in Fig. 1(a). Here, as shown in Fig. 1(b), on only one surface of insulating base material 11 of interconnect sheet 10, n-type-adapted interconnect 12 and p-type-adapted interconnect 13 are mounted.

Here, as a material for insulating base material 11, any electrically insulating material may be used without being particularly limited. For example, a material may be used that includes at least one resin selected from the group consisting of polyethylene terephthalate (PET), polyethylene naphthalate (PEN), polyphenylene sulfide (PPS), polyvinyl fluoride (PVF), and polyimide.

Likewise, the thickness of insulating base material 11 is not particularly limited, and may be for example 25 µm or more and 150 µm or less.

Insulating base material 11 may be of a single-layer structure formed of only one layer, or a multi-layer structure made up of two or more layers.

As a material for interconnect 16, any electrically conductive material may be used without being particularly limited as well. For example, a metal including at least one selected from the group consisting of copper, aluminum, and silver may be used.

Likewise, the thickness of interconnect 16 is not particularly limited, and may be for example 10 µm or more and 50 µm or less.

The shape of interconnect 16 is not limited as well to the above-described shape, and may of course be set as appropriate.

A surface of at least a part of interconnect 16 may be provided with an electrically conductive material including at least one selected from the group consisting of nickel (Ni), gold (Au), platinum (Pt), palladium (Pd), silver (Ag), tin (Sn), SnPb solder, and ITO (Indium Tin Oxide), for example. In this case, there is a tendency to be able to provide good electrical connection between interconnect 16 of interconnect sheet 10 and electrodes of a back contact solar cell which is described later herein, and improve the weather resistance of interconnect 16.

Further, a surface of at least a part of interconnect 16 may be subjected to surface treatment such as anti-rusting treatment or blackening treatment, for example.

Interconnect 16 may also be of a single-layer structure formed of one layer only or a multi-layer structure made up of two or more layers.

In the following, an example of the method for manufacturing interconnect sheet 10 of the configuration shown in Fig. 1(a) and Fig. 1(b) will be described.

First, insulating base material 11 such as PET film for example is prepared, and an electrically conductive material such as metal foil or metal plate for example is attached to the whole of one surface of insulating base material 11. Specifically, for example, a roll of the insulating base material which has been cut to a predetermined width may be unrolled, an adhesive may be applied to one surface of the insulating base material, then a roll of a metal foil which has been cut to a slightly smaller width than the insulating base material may be laid thereon, and pressure and heat may be applied to attach them to each other.

Next, a part of the electrically conductive material attached to the surface of insulating base material 11 is removed by photo etching or the like to pattern the electrically conductive material and thereby form, on the surface of insulating base material 11, interconnect 16 including for example n-type-adapted interconnect 12, p-type-adapted interconnect 13, and connection-adapted interconnect 14 formed of the patterned electrically conductive material.

In this way, interconnect sheet 10 configured as shown in Fig. 1(a) and Fig. 1(b) can be fabricated.

### <Back Contact Solar Cell>

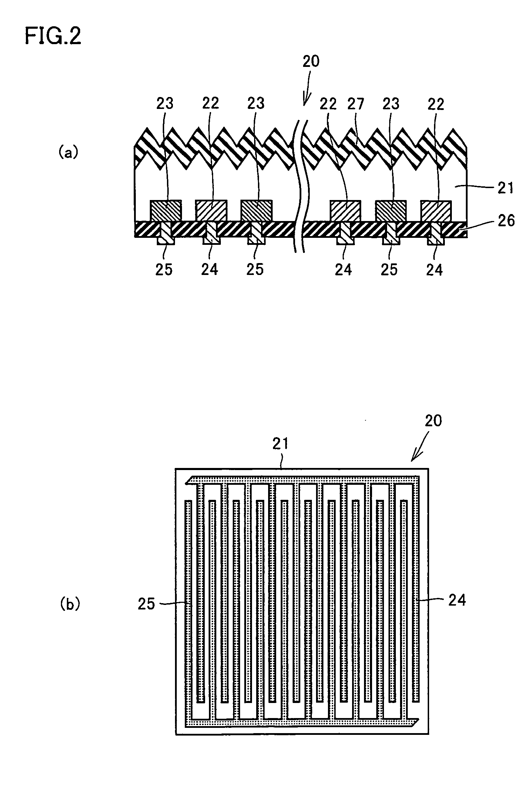

Fig. 2(a) shows a schematic cross section of an example of the back contact solar cell that is electrically connected to the interconnect of the interconnect sheet used in the first embodiment. Back contact solar cell 20 shown in Fig. 2(a) includes a semiconductor substrate 21 such as a silicon substrate of the n-type or p-type for example, an antireflection film 27 formed on a rough-surface side of semiconductor substrate 21 to serve as a light receiving surface of back contact solar cell 20, and a passivation film 26 formed on the back side of semiconductor substrate 21 to serve as the back surface of back contact solar cell 20.

Further, on the back side of semiconductor substrate 21, an n-type impurity diffused region 22 which is formed by diffusion of an n-type impurity such as phosphorus for example, and a p-type impurity diffused region 23 which is formed by diffusion of a p-type impurity such as boron are alternately formed with a predetermined space therebetween and, through respective contact holes made in passivation film 26 on the back side of semiconductor substrate 21, an n-type-adapted electrode 24 which contacts n-type impurity diffused region 22, and a p-type-adapted electrode 25 which contacts p-type impurity diffused region 23 are provided.

Here, on the back side of semiconductor substrate 21 having the n-type or p-type conductivity, a plurality of pn junctions are formed along the interface between n-type impurity diffused region 22 or p-type impurity diffused region 23 and the inside of semiconductor substrate 21. In any of the cases where semiconductor substrate 21 has the n-type conductivity and where it has the p-type conductivity, n-type impurity diffused region 22 and p-type impurity diffused region 23 are each joined to the inside of semiconductor substrate 21, and therefore, n-type-adapted electrode 24 and p-type-adapted electrode 25 are electrodes respectively corresponding to a plurality of pn junctions formed on the back side of semiconductor substrate 21.

Fig. 2(b) shows a schematic plan view of an example of semiconductor substrate 21 of back contact solar cell 20 shown in Fig. 2(a), as seen from the back side. Here, as shown in Fig. 2(b), n-type-adapted electrode 24 and p-type-adapted electrode 25 are each comb-shaped, and n-type-adapted electrode 24 and p-type-adapted electrode 25 are each arranged in such a manner that every single element corresponding to a comb tooth of comb-shaped n-type-adapted electrode 24 and every single element corresponding to a comb tooth of comb-shaped p-type-adapted electrode 25 interdigitate with each other. Accordingly, every single element corresponding to a comb tooth of comb-shaped n-type-adapted electrode 24 and every single element corresponding to a comb tooth of comb-shaped p-type-adapted electrode 25 are arranged alternately with a predetermined space therebetween.

Here, the shape and the arrangement of n-type-adapted electrode 24 and p-type-adapted electrode 25 each on the back surface of back contact solar cell 20 are not limited to those of the configuration shown in Fig. 2(b), and may be any shape and any arrangement that allow the electrodes to be electrically connected to n-type-adapted interconnect 12 and p-type-adapted interconnect 13 of interconnect sheet 10, respectively.

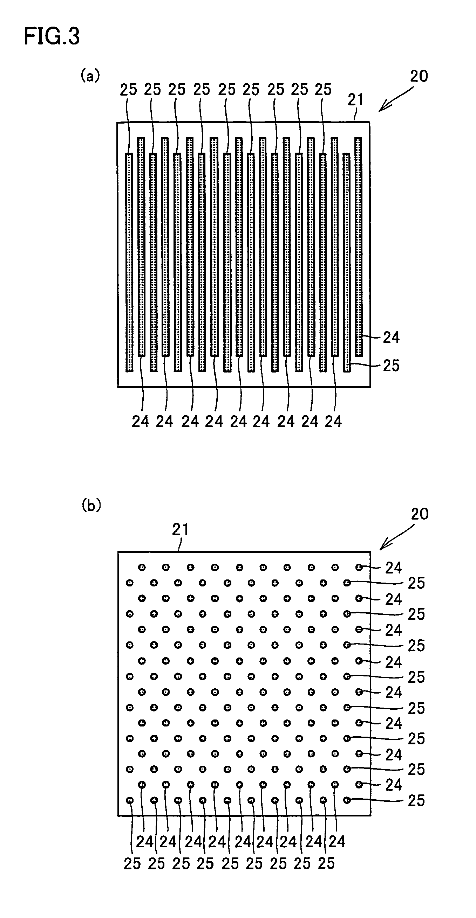

Fig. 3(a) shows a schematic plan view of another example of the back surface of semiconductor substrate 21 for back contact solar cell 20 shown in Fig. 2(a). Here, as shown in Fig. 3(a), n-type-adapted electrode 24 and p-type-adapted electrode 25 are respectively in the shape of strips extending along the same direction (extending along the top-bottom direction in Fig. 3(a)), and n-type-adapted electrode 24 and p-type-adapted electrode 25 are arranged in such a manner that every single element of n-type-adapted electrode 24 and every single element of p-type-adapted electrode 25 are alternately arranged orthogonally to the above-described direction along which the electrodes extend.

Fig. 3(b) shows a schematic plan view of still another example of the back surface of semiconductor substrate 21 for back contact solar cell 20 shown in Fig. 2(a). Here, as shown in Fig. 3(b), n-type-adapted electrode 24 and p-type-adapted electrode 25 are each dot-shaped, and every line of dot-shaped n-type-adapted electrode 24 (extending along the top-bottom direction in Fig. 3(b)) and every line of dot-shaped p-type-adapted electrode 25 (extending along the top-bottom direction in Fig. 3(b)) are alternately arranged on the back surface of semiconductor substrate 21. For the configurations illustrated in Fig. 2(a), Fig. 2(b), Fig. 3(a), and Fig. 3(b), at least a part of n-type-adapted electrode 24 and at least a part of p-type-adapted electrode 25 are each treated as every single element or every single line and the lines or elements are alternately arranged. Alternatively, at least one of n-type-adapted electrode 24 and p-type-adapted electrode 25 may be arranged so that every multiple elements or every multiple lines are arranged rather than every single element or every single line. In any case, at least one of n-type-adapted electrode 24 and p-type-adapted electrode 25 is at least partially arranged between elements of the other electrode.

Further, a surface of at least a part of n-type-adapted electrode 24 and/or a surface of at least a part of p-type-adapted electrode 25 for back contact solar cell 20 may be provided with an electrically conductive material including at least one selected from the group consisting of nickel (Ni), gold (Au), platinum (Pt), palladium (Pd), silver (Ag), tin (Sn), SnPb solder, and ITO (Indium Tin Oxide), for example. In this case, there is a tendency to be able to provide good electrical connection between interconnect 16 of interconnect sheet 10 and electrodes (n-type-adapted electrode 24, p-type-adapted electrode 25) of back contact solar cell 20, and improve the weather resistance of the electrodes (n-type-adapted electrode 24, p-type-adapted electrode 25) of back contact solar cell 20.

Further, a surface of at least a part of n-type-adapted electrode 24 and/or a surface of at least a part of p-type-adapted electrode 25 of back contact solar cell 20 may be subjected to surface treatment such as anti-rusting treatment or blackening treatment, for example.

Further, as semiconductor substrate 21, a silicon substrate or the like formed of n-type or p-type polycrystalline silicon or single-crystalline silicon for example may be used. Preferably, semiconductor substrate 21 is a single-crystalline substrate for pn junctions to be formed on the back side.

Further, as n-type-adapted electrode 24 and p-type-adapted electrode 25 each, an electrode of a metal such as silver for example may be used.

Further, as passivation film 26, a silicon oxide film, a silicon nitride film, or a laminate of a silicon oxide film and a silicon nitride film for example may be used.

Further, as antireflection film 27, a silicon nitride film for example may be used.

The back contact solar cell of the present invention is not intended to be limited only to the configuration where n-type-adapted electrode 24 and p-type-adapted electrode 25 are both formed on only one surface (back side) of above-described semiconductor substrate 21, but intended to encompass all so-called back contact solar cells (solar cells structured to allow electric current to be taken from the back side which is opposite to the light-receiving surface side of the solar cell), such as MWT (Metal Wrap Through) cell (a solar cell configured to arrange a part of electrodes in a through hole provided in a semiconductor substrate).

### <Solar Cell Module>

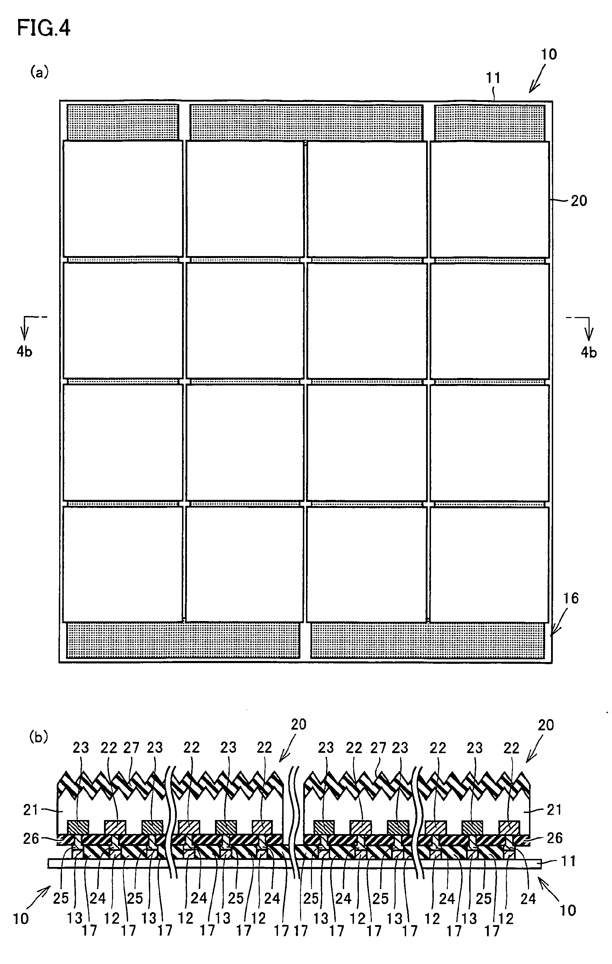

Fig. 4(a) shows a schematic plan view of an example of the solar cell module in the first embodiment, as seen from the light receiving surface side, and Fig. 4(b) shows a schematic cross section along 4b-4b in Fig. 4(a). A description will be given below of a configuration of an example of the solar cell module in the first embodiment, in which a plurality of back contact solar cells 20 shown in Figs. 2(a) and 2(b) are connected to interconnect 16 on the surface of interconnect sheet 10 shown in Figs. 1(a) and 1(b). The configuration of the solar cell module in the first embodiment, however, is not limit to the configuration shown in Figs. 4(a) and 4(b) as a matter of course. For example, a configuration in which a single back contact solar cell is connected to a single interconnect sheet may also be used. Here, as to the connection between the interconnect sheet and the back contact solar cell, any connection may be used as long as the connection enables electrical conduction of the interconnect of the interconnect sheet and the electrodes of the back contact solar cell.

As shown in Figs. 4(a) and 4(b), the solar cell module in the first embodiment is configured by mounting back contact solar cells 20 on interconnect sheet 10 so that the back side of back contact solar cells 20 and the interconnect 16 mounted side of interconnect sheet 10 are located opposite to each other.

Specifically, as shown in Fig. 4(b), n-type-adapted electrode 24 on the back side of back contact solar cell 20 is allowed to contact n-type-adapted interconnect 12 mounted on the surface of insulating base material 11 of interconnect sheet 10, and p-type-adapted electrode 25 on the back side of back contact solar cell 20 is allowed to contact p-type-adapted interconnect 13 mounted on the surface of insulating base material 11 of interconnect sheet 10. In this state, an insulating resin composition applied between electrodes adjacent to each other is cured. Then, the resin composition contracts when it adheres, in the space between electrodes of back contact solar cell 20, to insulating base material 11 of interconnect sheet 10, which generates a force that causes the electrodes of back contact solar cell 20 and the interconnects of the interconnect sheet 10 to contact each other. Accordingly, n-type-adapted electrode 24 of back contact solar cell 20 and n-type-adapted interconnect 12 of interconnect sheet 10 are electrically connected, and p-type-adapted electrode 25 of back contact solar cell 20 and p-type-adapted interconnect 13 of interconnect sheet 10 are electrically connected.

As shown in Fig. 1(a), n-type-adapted interconnect 12 and p-type-adapted interconnect 13 that are adjacent to each other are electrically connected by connection-adapted interconnect 14, except for n-type-adapted interconnect 12a and p-type-adapted interconnect 13a located on an end of interconnect sheet 10. Accordingly, back contact solar cells 20 mounted adjacently to each other on interconnect sheet 10 are electrically connected to each other. Therefore, in the solar cell module configured as shown in Figs. 4(a) and 4(b), all back contact solar cells 20 mounted on interconnect sheet 10 are electrically connected in series.

Here, an electric current generated from the light incident on the light receiving surface of back contact solar cell 20 of the solar cell module is drawn from n-type-adapted electrode 24 and p-type-adapted electrode 25 of back contact solar cell 20 to n-type-adapted interconnect 12 and p-type-adapted interconnect 13 of interconnect sheet 10. Then the current drawn to n-type-adapted interconnect 12 and p-type-adapted interconnect 13 of interconnect sheet 10 are drawn to the outside of the solar cell module from n-type-adapted interconnect 12a and p-type-adapted interconnect 13a that are each located on an end of interconnect sheet 10.

In the solar cell module of the present invention as shown in Fig. 4(b) for example, an electrically insulating cured resin 17 is provided between semiconductor substrate 21 of back contact solar cell 20 and insulating base material 11 of interconnect sheet 10, specifically in the region between n-type-adapted electrode 24 and p-type-adapted electrode 25 adjacent to each other of back contact solar cell 20, and therefore, the joint between back contact solar cell 20 and insulating base material 11 can further be strengthened. Here, insulating cured resin 17 may have an electrical resistance of such a degree that can substantially prevent occurrence of short circuit between n-type-adapted electrode 24 and p-type-adapted electrode 25 adjacent to each other of back contact solar cell 20 and between n-type-adapted interconnect 12 and p-type-adapted interconnect 13 adjacent to each other of interconnect sheet 10.

Further, n-type-adapted electrode 24 and p-type-adapted electrode 25 of back contact solar cell 20 may only abut respectively on n-type-adapted interconnect 12 and p-type-adapted interconnect 13 of interconnect 16 of interconnect sheet 10 without being secured thereto. In this case, even if a thermal stress such as a temperature change or a mechanical stress such as wind or accumulated snow is exerted on the solar cell module to cause a shear stress between back contact solar cell 20 and the interconnect, the stress acts on insulating cured resin 17 between the electrodes and between the interconnects. The connected parts are not secured but can be displaced temporarily depending on the stress, which can prevent breakage of the connected parts and improve the reliability.

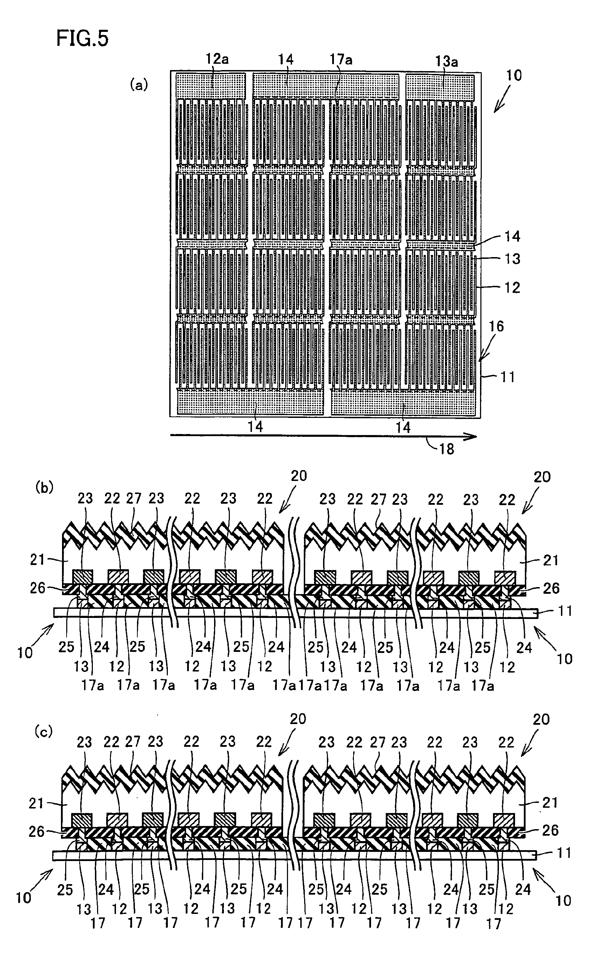

In the following, with reference to Figs. 5(a) to 5(c), a description will be given of an example of the method for manufacturing a solar cell module configured as shown in Figs. 4(a) and 4(b).

First, as shown in a schematic plan view of Fig. 5(a), interconnect sheet 10 configured as shown in Fig. 1(a) is prepared, and an electrically insulating resin composition 17a is applied to the interconnect 16 mounted surface of interconnect sheet 10. Accordingly, insulating resin composition 17a is provided between the comb teeth elements of comb-shaped n-type-adapted interconnect 12 and the comb teeth elements of comb-shaped p-type-adapted interconnect 13 of interconnect sheet 10. Here, insulating resin composition 17a may have an electrical resistance of such a degree that enables the above-described insulating cured resin 17 to be formed through curing as described later herein.

Here, the way to apply resin composition 17a is not particularly limited. For example, application by means of a dispenser, inkjet application, or slit coater may be used.

Further, resin composition 17a is preferably applied in a direction 18 which is substantially orthogonal to the longitudinal direction of the comb teeth elements of n-type-adapted interconnect 12 and to the longitudinal direction of the comb teeth elements of p-type-adapted interconnect 13, which are comb-shaped interconnects of interconnect sheet 10. In this case, when back contact solar cell 20 and interconnect sheet 10 are to be attached to each other, resin composition 17a wets and spreads along the longitudinal direction of n-type-adapted interconnect 12 and p-type-adapted interconnect 13, and there is a tendency to be able to apply resin composition 17a to the whole surface of back contact solar cell 20 while preventing air babbles from entering.

In the first embodiment, direction 18 which is substantially orthogonal to the longitudinal direction of the comb teeth elements of n-type-adapted interconnect 12 and to the longitudinal direction of the comb teeth elements of p-type-adapted interconnect 13 may, as a matter of course, be the direction which is completely orthogonal to the longitudinal direction of the comb teeth elements of n-type-adapted interconnect 12 and to the longitudinal direction of the comb teeth elements of p-type-adapted interconnect 13, or may be inclined by -14° to +14° relative to the direction completely orthogonal thereto.

Further, resin composition 17a preferably contains, as a resin component, any of an epoxy resin, an acrylic resin, and a resin mixture of an epoxy resin and an acrylic resin. In terms of the application property and the wetting and spreading property, the viscosity of the resin is desirably adjusted in a range of 1000 mPa·s to 10000 mPa·s. In this case, there is a tendency to be able to sufficiently fill the space between back contact solar cell 20 and interconnect sheet 10 and ensure a sufficient joint strength between back contact solar cell 20 and interconnect sheet 10. In the first embodiment, the resin component contained in resin composition 17a is, as a matter of course, not limited to epoxy resin, acrylic resin, and resin mixture of epoxy resin and acrylic resin.

Further, resin composition 17a may contain, other than the resin component, at least one conventionally known additive such as curing agent.

Next, as shown in a schematic cross section of Fig. 5(b), back contact solar cells 20 are mounted on interconnect sheet 10 to superpose back contact solar cells 20 and interconnect sheet 10 on each other, in such a manner that n-type-adapted electrode 24 of back contact solar cell 20 is located on n-type-adapted interconnect 12 of interconnect sheet 10 and p-type-adapted electrode 25 of back contact solar cell 20 is located on p-type-adapted interconnect 13 of interconnect sheet 10.

After this, resin composition 17a is heated and/or resin composition 17a is subjected to light for example, so as to cure resin composition 17a and thereby form electrically insulating cured resin 17 as shown in a schematic cross section of Fig. 5(c).

Here, in the first embodiment, resin composition 17a itself contracts, when cured resin 17 is to be formed by curing resin composition 17a. At this time, resin composition 17a adheres to passivation film 26 of back contact solar cell 20 and to insulating base material 11 of interconnect sheet 10, and therefore, the contraction force generated when resin composition 17a is cured further strengthens the joint between back contact solar cell 20 and interconnect sheet 10. Here, cured resin 17, which satisfies a relation "strength of adhesion to passivation film 26 of back contact solar cell 20 and to insulating base material 11 of interconnect sheet 10" > "cure contraction force" > "thermal expansion force" under conditions for use of the solar cell module, can thereby enable electrical connection between back contact solar cell 20 and interconnect sheet 10 to be kept.

In particular, a configuration like the above-described one where cured resin 17 is formed by curing resin composition 17a which is applied between semiconductor substrate 21 of back contact solar cell 20 and insulating base material 11 of interconnect sheet 10, specifically to the region between the comb teeth elements of comb-shaped n-type-adapted electrode 24 and the comb teeth elements of comb-shaped p-type-adapted electrode 25 that are adjacent to each other in back contact solar cell 20, and to the region between the comb teeth elements of comb-shaped n-type-adapted interconnect 12 and the comb teeth elements of comb-shaped p-type-adapted interconnect 13 that are adjacent to each other on insulating base material 11, can further strengthen the joint between back contact solar cell 20 and insulating base material 11 of interconnect sheet 10.

Further, the first embodiment, as compared with the above-referenced Patent Literature 1, can adequately fill the space between back contact solar cell 20 and interconnect sheet 10, ensure an adequate joint strength between back contact solar cell 20 and interconnect sheet 10, and improve the reliability of the connection.

Here, the solar cell module of the present invention is not intended to be limited to a solar cell module in which a plurality of back contact solar cells 20 are linearly and electrically connected to each other on the surface of interconnect sheet 10, but intended to encompass such a solar cell module in which a plurality of back contact solar cells 20 are electrically connected in a form such as matrix for example as shown in Fig. 4(a), other than the linear form.

### <Encapsulation of Solar Cell Module>

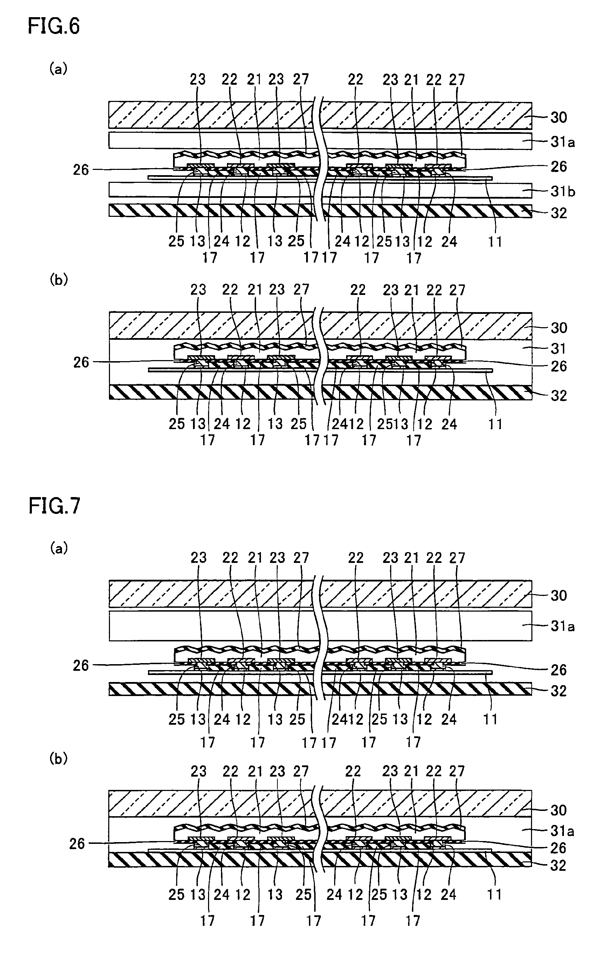

Figs. 6(a) and 6(b) each show a schematic cross section illustrating an example of the manufacturing method to encapsulate the solar cell module in the first embodiment. In the following, with reference to Figs. 6(a) and 6(b), a description will be given of an example of the manufacturing method to encapsulate the solar cell module in the first embodiment.

The following description concerns a solar cell module having a configuration in which the solar cell module configured as shown in Figs. 4(a) and 4(b) is encapsulated in an encapsulant, as an example of the solar cell module in the first embodiment. The configuration of the solar cell module in the first embodiment is, as a matter of course, not limited to this configuration.

First, as shown in Fig. 6(a), a transparent substrate 30 having a sheet-like first transparent resin 31a is mounted on the back contact solar cell side of the solar cell module configured as shown in Figs. 4(a) and 4(b), and a protective back sheet 32 having a sheet-like second transparent resin 31b is mounted on the interconnect sheet side of the solar cell module configured as shown in Figs. 4(a) and 4(b).

Next, first transparent resin 31a is pressure-joined to the back contact solar cells of the solar cell module, and second transparent resin 31b is pressure-joined to the interconnect sheet of the solar cell module. In this state, a heat treatment is performed to integrate and cure first transparent resin 31a and second transparent resin 31b. Accordingly, as shown in Fig. 6(b), the example of the solar cell module in the first embodiment is fabricated in which the above-described solar cell module is encapsulated in an encapsulant 31 made up of the integrated first transparent resin 31a and second transparent resin 31b.

In the solar cell module shown in Fig. 5(b), the contraction force generated by curing of cured resin 17 allows back contact solar cells 20 to be firmly pressure-joined to interconnect sheet 10, and the pressure joint between n-type-adapted electrode 24 of back contact solar cell 20 and n-type-adapted interconnect 12 of the interconnect sheet as well as the pressure joint between p-type-adapted electrode 25 of back contact solar cell 20 and p-type-adapted interconnect 13 of the interconnect sheet are each reinforced, so that good electrical connection is obtained between the electrodes of back contact solar cells 20 and the interconnects of interconnect sheet 10.

Here, the pressure joint and heat treatment for encapsulating the solar cell module in encapsulant 31 may be carried out by means of an apparatus, called laminator for example, for performing the vacuum pressure joint and heat treatment. For example, the laminator may be used to thermally deform first transparent resin 31a and second transparent resin 31b and thermally cure first transparent resin 31a and second transparent resin 31b to thereby integrate these transparent resins and form encapsulant 31, and the above-described solar cell module is encapsulated by being enclosed in encapsulant 31.

Here, the vacuum pressure joint refers to a process of pressure joint in an ambient of a pressure lower than the atmospheric pressure. Here, when the vacuum pressure joint is used as a pressure joint method, a gap is less likely to be formed between first transparent resin 31a and second transparent resin 31b, which is preferable in that air babbles are less likely to remain in encapsulant 31 formed by integrating first transparent resin 31a and second transparent resin 31b.

Here, as transparent substrate 30, any substrate may be used without being particularly limited, as long as the substrate is transparent to sunlight. A glass substrate for example may be used.

Further, as first transparent resin 31a and second transparent resin 31b, any resin transparent to sunlight may be used without being particularly limited. In particular, it is preferable to use at least one transparent resin selected from the group consisting of ethylene vinyl acetate resin, epoxy resin, acrylic resin, urethane resin, olefin-based resin, polyester resin, silicone resin, polystyrene resin, polycarbonate resin, and rubber-based resin. In this case, encapsulant 31 is excellent in weather resistance and the sunlight permeability is high. Therefore, without a significant loss of the output of the solar cell module (particularly short circuit current or operating current), adhesion to transparent substrate 30 can be made with an adequate strength. There is thus a tendency to be able to ensure long-term reliability of the solar cell module.

Further, as first transparent resin 31a and second transparent resin 31b, the same transparent resin may be used, or different transparent resins may be used respectively.

Further, the heat treatment for encapsulating the above-described solar cell module in encapsulant 31 may be performed, in the case for example where first transparent resin 31a and second transparent resin 31b are each formed of ethylene vinyl acetate resin, by heating first transparent resin 31a and second transparent resin 31b each to a temperature for example of 100°C or more and 200°C or less.

Further, as protective back sheet 32, any sheet may be used without being particularly limited, as long as it can protect the back surface of encapsulant 31. For example, a weather-resistant film such as PET which has conventionally been used may be used.

Further, in order to ensure long-term reliability by adequately suppressing transmission of water vapor or oxygen into encapsulant 31, protective back sheet 32 may include a film of a metal such as aluminum for example.

Further, for any portion to which tight adhesion of protective back sheet 32 is difficult, such as an end face of the solar cell module, complete adhesion can also be achieved by means of an anti-water-transmission tape such as butyl rubber tape for example.

Figs. 7(a) and 7(b) each show a schematic cross section illustrating another example of the manufacturing method to encapsulate an example of the solar cell module in the first embodiment. In the following, with reference to Figs. 7(a) and 7(b), another example of the manufacturing method to encapsulate an example of the solar cell module in the first embodiment will be described. While the following description concerns a solar cell module configured by encapsulating in an encapsulant the solar cell module configured as shown in Figs. 4(a) and 4(b), as an example of the solar cell module in the first embodiment, the configuration of the solar cell module in the first embodiment is, as a matter of course, not limited to this.

First, as shown in Fig. 7(a), only the protective back sheet 32 is mounted on the interconnect sheet side of the solar cell module, and transparent substrate 30 having sheet-like first transparent resin 31a is mounted on the back contact solar cell side of the solar cell module.

Next, first transparent resin 31a is pressure-joined to back contact solar cells of the solar cell module. In this state, a heat treatment is performed to thereby enclose and thus encapsulate the solar cell module in first transparent resin 31a as shown in Fig. 7(b). In this way, an example of the solar cell module in the first embodiment in which the above-described solar cell module is encapsulated in first transparent resin 31a is fabricated.

In the example of the solar cell module in the first embodiment fabricated in the above-described manner, an electric current generated from the light incident on the light receiving surface of the back contact solar cell is drawn from n-type-adapted electrode 24 and p-type-adapted electrode 25 of the back contact solar cell to n-type-adapted interconnect 12 and p-type-adapted interconnect 13 of the interconnect sheet, respectively. Then, the current drawn to n-type-adapted interconnect 12 and p-type-adapted interconnect 13 of the interconnect sheet is drawn to the outside, through protective back sheet 32, from terminals electrically connected to n-type-adapted interconnect 12a and p-type-adapted interconnect 13a that are each located on an end of interconnect sheet 10.

Further, in the example of the solar cell module in the first embodiment fabricated in the above-described manner, a frame made for example of an aluminum alloy may be attached to surround the outer periphery of the solar cell module.

Here, at least a part of cured resin 17 of the solar cell module before being encapsulated may be left uncured, and the heat treatment for encapsulation with encapsulant 13 may be used to cure resin 17 which is left uncured.

### <Solar Cell Equipped with Interconnect Sheet>

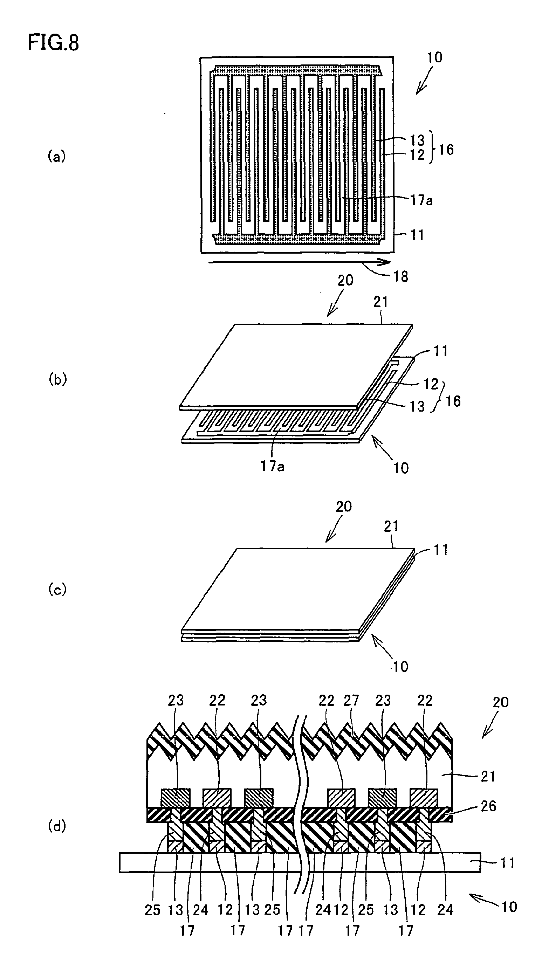

Figs. 8(a) to 8(d) illustrate an example of the method for manufacturing an example of a solar cell equipped with an interconnect sheet in the first embodiment. In the following, with reference to Figs. 8(a) to 8(d), a description will be given of an example of the method for manufacturing an example of a solar cell equipped with an interconnect sheet in the first embodiment.

The following description concerns a solar cell equipped with an interconnect sheet configured by electrically connecting one of back contact solar cells 20 shown in Figs. 2(a) and 2(b) to interconnect 16 of interconnect sheet 10 shown in Fig. 8(a), as an example of a solar cell equipped with an interconnect sheet in the first embodiment. The solar cell equipped with the interconnect sheet in the first embodiment is, as a matter of course, not limited to this configuration.

First, as shown in a schematic plan view of Fig. 8(a), interconnect sheet 10 for one back contact solar cell is prepared. Here, interconnect sheet 10 with the configuration shown in Fig. 8(a) has insulating base material 11, and interconnect 16 including comb-shaped n-type-adapted interconnect 12 and comb-shaped p-type-adapted interconnect 13 patterned on the surface of insulating base material 11.

Here again, n-type-adapted interconnect 12 and p-type-adapted interconnect 13 are arranged in such a manner that every single element corresponding to a comb tooth of comb-shaped n-type-adapted interconnect 12 and every single element corresponding to a comb tooth of comb-shaped p-type-adapted interconnect 13 interdigitate with each other. Accordingly, every single element corresponding to a comb tooth of comb-shaped n-type-adapted interconnect 12 and every single element corresponding to a comb tooth of comb-shaped p-type-adapted interconnect 13 interdigitate with each other with a predetermined space therebetween.

Then, electrically insulating resin composition 17a is applied to the surface, on which interconnect 16 is mounted, of interconnect sheet 10. Thus, insulating resin composition 17a is provided between a comb tooth element of n-type-adapted interconnect 12 and a comb tooth element of comb-shaped p-type-adapted interconnect 13 of interconnect sheet 10.

Here again, for a similar reason to the reason described in connection with the above-described method for manufacturing the solar cell module, resin composition 17a is preferably applied in direction 18 substantially orthogonal to the longitudinal direction of the comb teeth elements of comb-shaped n-type-adapted interconnect 12 and to the longitudinal direction of the comb teeth elements of comb-shaped p-type-adapted interconnect 13 of interconnect sheet 10.

A description about application of resin composition 17a is similar to the description given above in connection with the above-described method for manufacturing the solar cell module, and will not be given here.

Next, as shown in a schematic perspective view of Fig. 8(b), back contact solar cell 20 is moved to above the surface of interconnect 16 of interconnect sheet 10. Then, the back side of back contact solar cell 20 and the interconnect 16 mounted side of interconnect sheet 10 are made opposite to each other, and the position of back contact solar cell 20 is adjusted so that n-type-adapted electrode 24 of back contact solar cell 20 is electrically connected to n-type-adapted interconnect 12 of interconnect sheet 10 and p-type-adapted electrode 25 of back contact solar cell 20 is electrically connected to p-type-adapted interconnect 13 of interconnect sheet 10.

Next, as shown in a schematic perspective view of Fig. 8(c), n-type-adapted electrode 24 on the back surface of back contact solar cell 20 is mounted on n-type-adapted interconnect 12 of interconnect sheet 10, and p-type-adapted electrode 25 of back contact solar cell 20 is mounted on p-type-adapted interconnect 13 of interconnect sheet 10 to thereby mount back contact solar cell 20 on interconnect sheet 10.

Then, resin composition 17a is heated and/or resin composition 17a is subjected to light for example so as to cure resin composition 17a and form cured resin 17 as shown in a schematic cross section of Fig. 8(d). In this way, n-type-adapted electrode 24 on the back surface of back contact solar cell 20 and n-type-adapted interconnect 12 of interconnect sheet 10 are joined to each other, and p-type-adapted electrode 25 on the back surface of back contact solar cell 20 and p-type-adapted interconnect 13 of interconnect sheet 10 are joined to each other to thereby fabricate an example of the solar cell equipped with the interconnect sheet in the first embodiment.

Namely, as shown in Fig. 8(d), n-type-adapted electrode 24 on the back surface of back contact solar cell 20 is joined to n-type-adapted interconnect 12 mounted on the surface of insulating base material 11 of interconnect sheet 10, and p-type-adapted electrode 25 on the back surface of back contact solar cell 20 is joined to p-type-adapted interconnect 13 mounted on the surface of insulating base material 11 of interconnect sheet 10. Therefore, n-type-adapted electrode 24 of back contact solar cell 20 is electrically connected to n-type-adapted interconnect 12 of interconnect sheet 10, and p-type-adapted electrode 25 of back contact solar cell 20 is electrically connected to p-type-adapted interconnect 13 of interconnect sheet 10.

In the example of the solar cell equipped with the interconnect sheet in the first embodiment that is configured in the above-described manner, an electric current generated from the light incident on the light receiving surface of back contact solar cell 20 is drawn from n-type-adapted electrode 24 and p-type-adapted electrode 25 of back contact solar cell 20 to the outside through n-type-adapted interconnect 12 and p-type-adapted interconnect 13 of interconnect sheet 10, respectively.

Further, the solar cell equipped with the interconnect sheet in the first embodiment may be encapsulated in the above-described encapsulant, like the above-described solar cell module.

The example of the solar cell equipped with the interconnect sheet in the first embodiment that is configured in the above-described manner can be downsized, and therefore is applicable for example to a power supply of a mobile phone.

Regarding the method for manufacturing the solar cell module and that for the solar cell equipped with the interconnect sheet in the first embodiment above, the region where insulating resin composition 17a is applied to the interconnect 16 mounted side of interconnect sheet 10 may be any of the whole surface of interconnect sheet 10, the region where back contact solar cell 20 is to be attached, and only the region between n-type-adapted interconnect 12 and p-type-adapted interconnect 13.

Further, regarding the method for manufacturing the solar cell module and that for the solar cell equipped with the interconnect sheet in the first embodiment, insulating resin composition 17a may be applied, not to the interconnect 16 mounted surface of interconnect sheet 10, but to the surface, on which n-type-adapted electrode 24 and p-type-adapted electrode 25 are mounted, of back contact solar cell 20.

At this time, resin composition 17a may be applied to any of the whole surface of back contact solar cell 20, a region of back contact solar cell 20 except for a peripheral portion thereof, and only the region between n-type-adapted electrode 24 and p-type-adapted electrode 25. In the case where the region to which resin composition 17a is applied includes interconnect 16 of interconnect sheet 10 and electrodes (n-type-adapted electrode 24 and p-type-adapted electrode 25) of back contact solar cell 20, a pressure is preferably applied when cured resin 17 is formed from resin composition 17a. In this way, resin composition 17a located between interconnect 16 of interconnect sheet 10 and the electrodes of back contact solar cell 20 is pushed out, and the electrical connection between back contact solar cell 20 and interconnect sheet 10 can further be ensured.

At this time, the way to apply resin composition 17a may be any such as printing, dispensing, spin coat, roll coat, spray coat, and slit coat, for example.

### Second Embodiment

A second embodiment is characterized by that an electrically insulating cured resin is formed by curing an electrically insulating resin composition in at least two stages. Specifically, the insulating resin composition in the second embodiment can be converted to at least a B stage cure state and a C stage cure state, and the insulating cured resin is characterized by that it is formed by curing the resin composition in at least two stages. Here, the B stage cure state means that the insulating resin composition is in an intermediate cure state, namely the state in which the resin composition is in fact cured, but can be softened again by being subjected to heating or the like. The C stage cure state means that the insulating resin composition is finally cured into a cured resin, namely the state in which it will not be softened again. An electrically insulating resin composition that can be converted to at least two stages: B stage cure state and C stage cure state, is herein referred to as B stage cure type resin composition.

### <Solar Cell Module>

In the second embodiment, insulating cured resin 17 which is provided between semiconductor substrate 21 of back contact solar cell 20 of the solar cell module shown for example in Figs. 4(a) and 4(b) and insulating base material 11 of interconnect sheet 10, specifically in the region between electrodes adjacent to each other of interconnect sheet 10 is formed by being cured in at least two stages.

Here, curing in two stages means that a resin composition is converted into a final cure state (C stage cure state) through an intermediate cure state (B stage cure state). Specifically, an insulating resin composition is cured for example by a method described later herein. Thus, in a solar cell module in which the resin composition is cured in at least two stages, voids between the resin composition in an intermediate cure state (intermediate cure resin) and interconnect sheet 10 and voids between the resin composition and back contact solar cell 20 can easily be removed. Therefore, a solar cell module can be fabricated in which generation of a void between interconnect sheet 10 and back contact solar cell 20 is suppressed. Further, migration of materials for the electrodes and the interconnects that is induced by accumulation of moisture in a void, and a stress concentration in a region where an electrode is press-joined, due to the presence of a void, for example, can be prevented, which improves the reliability of the solar cell module.

In the solar cell module of the second embodiment, as shown for example in Fig. 4(b), insulating cured resin 17, which is formed by curing a B stage cure type resin composition in at least two stages, is provided between semiconductor substrate 21 of back contact solar cell 20 and insulating base material 11 of interconnect sheet 10, specifically in a region between n-type-adapted electrode 24 and p-type-adapted electrode 25 adjacent to each other of back contact solar cell 20, and therefore, the joint between back contact solar cell 20 and insulating base material 11 can further be strengthened.

Further, n-type-adapted electrode 24 and p-type-adapted electrode 25 of back contact solar cell 20 and n-type-adapted interconnect 12 and p-type-adapted interconnect 13 of interconnect 16 of interconnect sheet 10 may only abut on each other rather than being secured to each other. Thus, even if the solar cell module is subjected to a thermal stress such as a temperature change or a mechanical stress such as wind or accumulated snow and accordingly a shearing stress is generated between back contact solar cell 20 and the interconnect, the stress is exerted on insulating cured resin 17 between the electrodes and between the interconnects. Since the parts connected to each other are not fixed, they can temporarily be displaced depending on the stress. The connected parts can thus be prevented from being broken, which can improve the reliability of the solar cell module.

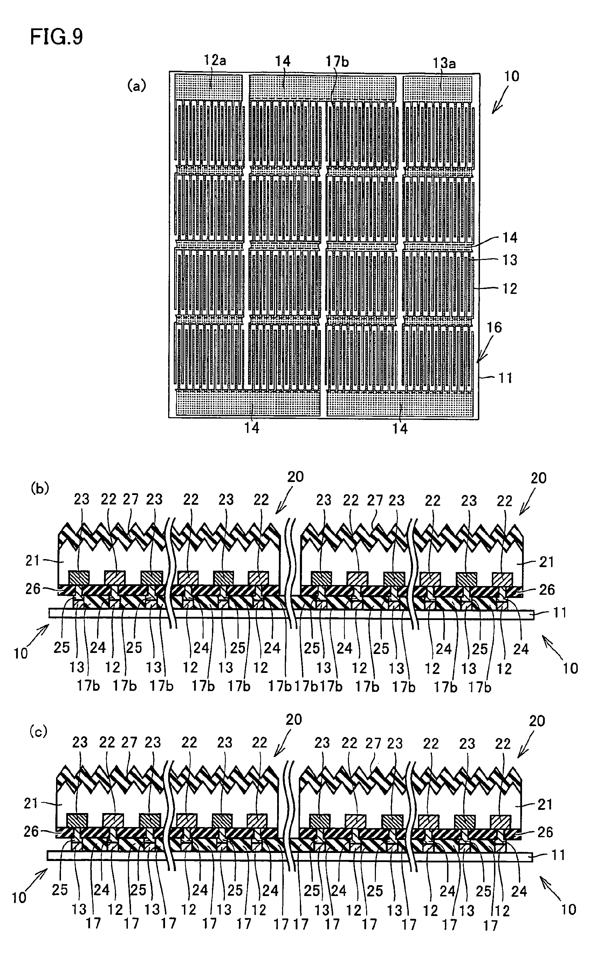

In the following, with reference to Figs. 9(a) to 9(c), an example of the method for manufacturing the solar cell module in the second embodiment will be described.

First, as shown in a schematic plan view of Fig. 9(a), interconnect sheet 10 configured as shown in Fig. 1(a) is prepared and, to the interconnect 16 mounted surface of interconnect sheet 10, an electrically insulating resin composition 17b of the B stage cure (two-stage cure) type is applied. Accordingly, between a comb tooth element of comb-shaped n-type-adapted interconnect 12 and a comb tooth element of comb-shaped p-type-adapted interconnect 13 of interconnect sheet 10, insulating resin composition 17b is provided. Here, insulating resin composition 17b may have an electrical resistance of such a degree that enables above-described insulating cured resin 17 to be formed by a curing process described later herein.

Here, the way to apply resin composition 17b is not particularly limited. Application by means of a dispenser, ink jet application, application by means of a slit coater, or printing with a metal mask, screen mask, or the like, for example, may be used.

Further, resin composition 17b is preferably a resin composition of the B stage cure (two-stage cure) type containing, as a resin component, any of an epoxy resin, an acrylic resin, and a resin mixture of these resins. In this case, voids between the resin composition in the intermediate cure state (intermediate cure resin) and interconnect sheet 10 and voids between the resin composition and back contact solar cell 20 can easily be removed. Therefore, there is a tendency to be able to fabricate a solar cell module in which occurrence of a void between interconnect sheet 10 and back contact solar cell 20 is suppressed. In the second embodiment, the resin component contained in resin composition 17b is, as a matter of course, not limited to the above-mentioned resins.

Further, resin composition 17b may contain at least one conventionally known additive such as curing agent, as a component other than the resin component.

Next, resin composition 17b is heated or subjected to light to be thereby dried to remove a solvent, and thereby solidified, or heated or subjected to light to be cured into an intermediate cure state (B stage cure state). Here, in the case where the intermediate cure state is generated by application of light, it is preferable to use, as insulating base material 11 of interconnect sheet 10, a material which is transparent to the light by which resin composition 17b is cured, and light is applied from this insulating base material 11. Preferably, the surface of resin composition 17b which is solidified or converted to an intermediate cure state (B stage cure state) has a low-tackiness state.

Next, as shown in a schematic cross section of Fig. 9(b), back contact solar cell 20 is placed on interconnect sheet 10 so that n-type-adapted electrode 24 of back contact solar cell 20 is located on n-type-adapted interconnect 12 of interconnect sheet 10, and p-type-adapted electrode 25 of back contact solar cell 20 is located on p-type-adapted interconnect 13 of interconnect sheet 10, and interconnect sheet 10 and back contact solar cell 20 are superposed on each other. After this, back contact solar cell 20 and interconnect sheet 10 are press-joined to allow, as shown in the schematic cross section of Fig. 9(b), n-type-adapted electrode 24 and p-type-adapted electrode 25 of back contact solar cell 20 to abut respectively on n-type-adapted interconnect 12 and p-type-adapted interconnect 13 of interconnect sheet 10. The press joint may be performed while applying heat.

Here, in the case where the surface of resin composition 17b in the intermediate cure state (B stage cure state) has a low-tackiness state, positional adjustment is easy when interconnect sheet 10 and back contact solar cell 20 are to be superposed on each other while the positional adjustment is done so that n-type-adapted electrode 24 and p-type-adapted electrode 25 of back contact solar cell 20 are associated with n-type-adapted interconnect 12 and p-type-adapted interconnect 13 of interconnect sheet 10. Therefore, the tackiness of the surface of resin composition 17b in the intermediate cure state (B stage cure state) is preferably low to such a degree that enables the interconnect 16 mounted side of interconnect sheet 10 and/or the back side of back contact solar cell 20 to be separated from the surface of resin composition 17b without resistance even if they contact the surface of the resin composition.

Further, in the case where the surface of resin composition 17b in the intermediate cure state (B stage cure state) has a low-tackiness state, when the press joint is performed while the surface of resin composition 17b and insulating base material 11 of interconnect sheet 10 and/or the back surface of back contact solar cell 20 abutting on the surface of the resin composition have a gap therebetween, the gap can be prevented from becoming a void by being enclosed in the surrounding resin composition 17b. Further, when the press joint is performed in a decompressed state, resin composition 17b located around the gap flows to fill the gap, which is preferable in that occurrence of a void can further be suppressed.

The tackiness of resin composition 17b in the B stage cure state (intermediate cure state) can for example be evaluated by the probe tack method. For example, the tackiness of the surface of resin composition 17b in the B stage cure state (intermediate cure state) is preferably less than 500 gf measured by means of a probe of 5 mm in diameter of a tacking tester manufactured by Rhesca Corporation, under the conditions including a descending speed of 1.0 mm/sec, a lifting speed of 600 mm/sec, a load of 100 gf, a press time of one second, a measurement distance of 5 mm, and a measurement temperature of 23°C.

After this, resin composition 17b is heated and/or resin composition 17b is subjected to light for example so that resin composition 17b becomes the final cure state (C stage cure state), and thereby forming insulating cured resin 17 as shown in a schematic cross section of Fig. 9(c). Here, in the case where the resin is subjected to light to be cured, preferably a material which is transparent to the light with which resin composition 17b is cured is used as insulating base material 11 of interconnect sheet 10 and the light is applied from this insulating base material 11.

Here, in the second embodiment, resin composition 17b itself contracts, when cured resin 17 is to be formed by curing resin composition 17b. At this time, resin composition 17b adheres to passivation film 26 of back contact solar cell 20 and to insulating base material 11 of interconnect sheet 10, and therefore, the contraction force generated when resin composition 17b is cured further strengthens the joint between back contact solar cell 20 and interconnect sheet 10. Here, cured resin 17, which satisfies a relation "strength of adhesion to passivation film 26 of back contact solar cell 20 and to insulating base material 11 of interconnect sheet 10" > "cure contraction force" > "thermal expansion force" under conditions for use of the solar cell module, can thereby enable electrical connection between back contact solar cell 20 and interconnect sheet 10 to be kept.

In particular, a configuration like the above-described one where cured resin 17 is formed by curing resin composition 17b in at least two stages that is applied between semiconductor substrate 21 of back contact solar cell 20 and insulating base material 11 of interconnect sheet 10, specifically to the region between the comb teeth elements of comb-shaped n-type-adapted electrode 24 and the comb teeth elements of comb-shaped p-type-adapted electrode 25 that are adjacent to each other in back contact solar cell 20, and to the region between the comb teeth elements of comb-shaped n-type-adapted interconnect 12 and the comb teeth elements of comb-shaped p-type-adapted interconnect 13 that are adjacent to each other on insulating base material 11, can further strengthen the joint between back contact solar cells 20 and insulating base material 11 of interconnect sheet 10.

Further, the second embodiment, as compared with the above-referenced Patent Literature 1, can adequately fill the space between back contact solar cell 20 and interconnect sheet 10, ensure an adequate joint strength between back contact solar cell 20 and interconnect sheet 10, and improve the reliability of the connection.

Here, the solar cell module in the second embodiment is not intended to be limited to a solar cell module in which a plurality of back contact solar cells 20 are linearly and electrically connected to each other on the surface of interconnect sheet 10, but intended to encompass such a solar cell module in which a plurality of back contact solar cells 20 are electrically connected in a form such as matrix for example as shown in Fig. 4(a), other than the linear form.

Further, regarding the method for manufacturing a solar cell module and a solar cell equipped with an interconnect sheet in the second embodiment, it is preferable that resin composition 17b which is applied onto back contact solar cell 20 and/or interconnect sheet 10 is solidified by being heated and/or subjected to light and thereby dried to remove the solvent, or converted to the B stage cure state (intermediate cure state) by being heated and/or subjected to light, and the back contact solar cell 20 and interconnect sheet 10 are superposed on each other. The tackiness of the surface of resin composition 17b in the B stage cure state (intermediate cure state) is similar to the above-described one, and the description will not be repeated here.

Further, regarding the method for manufacturing a solar cell module and a solar cell equipped with an interconnect sheet in the second embodiment, the region where insulating resin composition 17b is applied to the interconnect 16 mounted side of interconnect sheet 10 may be any of the whole surface of interconnect sheet 10, the region where back contact solar cell 20 is to be attached, and only the region between n-type-adapted interconnect 12 and p-type-adapted interconnect 13.

Further, in the second embodiment, resin composition 17b may be applied, not to the interconnect 16 mounted surface of interconnect sheet 10, but to the surface, on which n-type-adapted electrode 24 and p-type-adapted electrode 25 are mounted, of back contact solar cell 20.

At this time, resin composition 17b may be applied to any of the whole surface of back contact solar cell 20, a region of back contact solar cell 20 except for a peripheral portion thereof, and only the region between n-type-adapted electrode 24 and p-type-adapted electrode 25. In the case where the region to which resin composition 17b is applied includes interconnect 16 of interconnect sheet 10 and n-type-adapted electrode 24 and p-type-adapted electrode 25 of back contact solar cell 20, a pressure is preferably applied when cured resin 17 is formed from resin composition 17b. In this way, resin composition 17b located between interconnect 16 of interconnect sheet 10 and the electrodes of back contact solar cell 20 is pushed out, and the electrical connection between back contact solar cell 20 and interconnect sheet 10 can further be ensured.

At this time, the way to apply resin composition 17b may be any such as printing, dispensing, spin coat, roll coat, spray coat, and slit coat, for example.

Further, in resin composition 17b, preferably a contained element including a halogen-based element has a low concentration.

Further, regarding the amount of resin composition 17b to be applied, it is preferable that only an amount that fills the space between back contact solar cell 20 and interconnect sheet 10, in the state where n-type-adapted electrode 24 and p-type-adapted electrode 25 of back contact solar cell 20 and n-type-adapted interconnect 12 and p-type-adapted interconnect 13 of interconnect sheet 10 are electrically connected and resin composition 17b is cured, is applied in advance to the surface of back contact solar cell 20 or to the surface of interconnect sheet 10.

Further, the amount of resin composition 17b to be applied may be slightly larger than the amount of the resin composition that fills the space between back contact solar cell 20 and interconnect sheet 10. In this case, resin composition 17b spreads around back contact solar cell 20 and is then cured, and therefore, the joint between back contact solar cell 20 and interconnect sheet 10 can further be strengthened.

Here, as to the method for manufacturing a solar cell module and that for a solar cell equipped with an interconnect sheet in the second embodiment, n-type-adapted electrode 24 and p-type-adapted electrode 25 of back contact solar cell 20 and n-type-adapted interconnect 12 and p-type-adapted interconnect 13 of interconnect sheet 10 may be electrically connected by any method such as for example pressure welding, solder joint, metal joint, conductive adhesive, anisotropic conductive adhesive, or non-conductive adhesive.

Further, regarding the method for manufacturing a solar cell module and that for a solar cell equipped with an interconnect sheet in the second embodiment, the step of curing insulating resin composition 17b located between semiconductor substrate 21 of back contact solar cell 20 and insulating base material 11 of interconnect sheet 10, specifically in a region between n-type-adapted electrode 24 and p-type-adapted electrode 25 adjacent to each other of back contact solar cell 20 to thereby form insulating cured resin 17, and the step of electrically connecting n-type-adapted electrode 24 and p-type-adapted electrode 25 of back contact solar cell 20 to n-type-adapted interconnect 12 and p-type-adapted interconnect 13 of interconnect sheet 10, respectively, may be carried out together in a single step.

Further, as to the method for manufacturing a solar cell module in the second embodiment, the step of curing insulating resin composition 17b between semiconductor substrate 21 of back contact solar cell 20 and insulating base material 11 of interconnect sheet 10, specifically in a region between electrodes 24, 25 adjacent to each other of back contact solar cell 20 to thereby form insulating cured resin 17, the step of electrically connecting n-type-adapted electrode 24 and p-type-adapted electrode 25 of back contact solar cell 20 to n-type-adapted interconnect 12 and p-type-adapted interconnect 13 of interconnect sheet 10, respectively, and the step of encapsulating a solar cell string between a transparent substrate such as glass substrate and a protective back sheet may be carried out together in a single step.

### <Solar Cell Equipped with Interconnect Sheet>

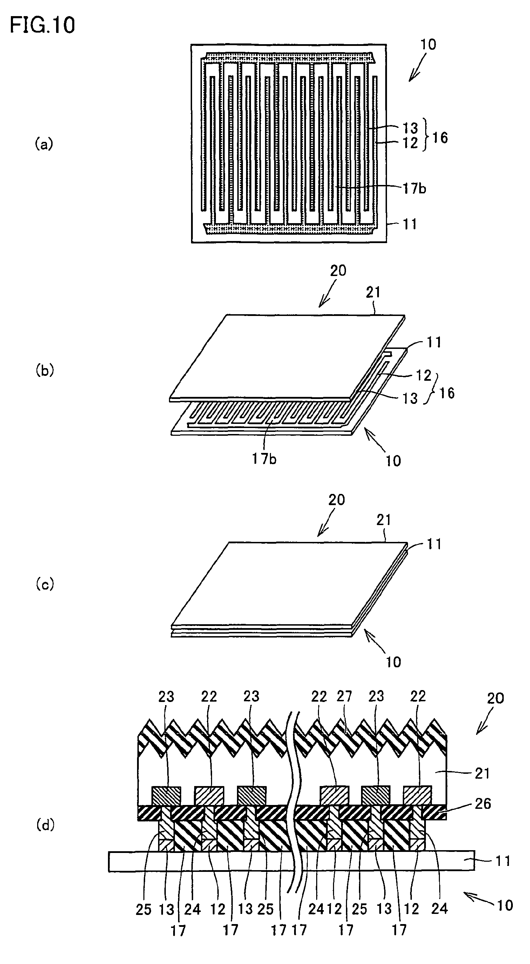

Figs. 10(a) to 10(d) illustrate another example of the method for manufacturing an example of a solar cell equipped with an interconnect sheet in the second embodiment. In the following, with reference to Figs. 10(a) to 10(d), a description will be given of another example of the method for manufacturing an example of a solar cell equipped with an interconnect sheet in the second embodiment.

The following description concerns a solar cell equipped with an interconnect sheet configured by electrically connecting one of back contact solar cells 20 shown in Figs. 2(a) and 2(b) to interconnect 16 of interconnect sheet 10 shown in Fig. 10(a), as an example of a solar cell equipped with an interconnect sheet in the second embodiment. The solar cell equipped with the interconnect sheet in the second embodiment is, as a matter of course, not limited to this configuration.

First, as shown in a schematic plan view of Fig. 10(a), interconnect sheet 10 for one back contact solar cell is prepared. Here, interconnect sheet 10 with the configuration shown in Fig. 10(a) has insulating base material 11, and interconnect 16 including comb-shaped n-type-adapted interconnect 12 and comb-shaped p-type-adapted interconnect 13 patterned on the surface of insulating base material 11.

Here again, n-type-adapted interconnect 12 and p-type-adapted interconnect 13 are arranged in such a manner that every single element corresponding to a comb tooth of comb-shaped n-type-adapted interconnect 12 and every single element corresponding to a comb tooth of comb-shaped p-type-adapted interconnect 13 interdigitate with each other. Accordingly, every single element corresponding to a comb tooth of comb-shaped n-type-adapted interconnect 12 and every single element corresponding to a comb tooth of comb-shaped p-type-adapted interconnect 13 interdigitate with each other with a predetermined space therebetween.

Then, resin composition 17b is applied to the surface, on which interconnect 16 is mounted, of interconnect sheet 10. This resin composition 17b is converted to the intermediate cure state (B stage cure state) to form an intermediate cure resin, by a similar method to the above-described one.

Here, the application of resin composition 17b and the intermediate cure state (B stage cure state) are similar to the above-described ones, and the description will not be repeated here.

Next, as shown in a schematic perspective view of Fig. 10(b), back contact solar cell 20 is moved to above the surface of interconnect 16 of interconnect sheet 10. Then, the back side of back contact solar cell 20 and the interconnect 16 mounted side of interconnect sheet 10 are made opposite to each other, and the position of back contact solar cell 20 is adjusted so that n-type-adapted electrode 24 of back contact solar cell 20 is electrically connected to n-type-adapted interconnect 12 of interconnect sheet 10 and p-type-adapted electrode 25 of back contact solar cell 20 is electrically connected to p-type-adapted interconnect 13 of interconnect sheet 10.

Next, as shown in a schematic perspective view of Fig. 10(c), n-type-adapted electrode 24 on the back surface of back contact solar cell 20 is mounted on n-type-adapted interconnect 12 of interconnect sheet 10, and p-type-adapted electrode 25 of back contact solar cell 20 is mounted on p-type-adapted interconnect 13 of interconnect sheet 10 to thereby mount back contact solar cell 20 on interconnect sheet 10 and superpose interconnect sheet 10 and back contact solar cell 20 on each other. Then, interconnect sheet 10 and back contact solar cell 20 superposed on each other are subjected to a pressure while being heated, to pressure-join n-type-adapted interconnect 12 of interconnect sheet 10 and n-type-adapted electrode 24 of back contact solar cell 20 and pressure-join p-type-adapted interconnect 13 of interconnect sheet 10 and p-type-adapted electrode 25 of back contact solar cell 20. The pressure joint is carried out by applying a pressure to the intermediate cure resin which has been formed by converting resin composition 17b to the intermediate cure state (B stage cure state) and is in a melt state of a reduced viscosity by being heated. At this time, heat and pressure may be applied simultaneously, heat may be applied after pressure is applied, or pressure may be applied after heat is applied. A description of the tackiness of the surface of resin composition 17b in the B stage cure state (intermediate cure state) is similar to the above-described one, and the description thereof will not be repeated here.

Then, the intermediate cure resin, which has been formed by converting resin composition 17b to the intermediate cure state (B stage cure state), is heated and/or subjected to light so that the intermediate cure resin is cured to form insulating cured resin 17 as shown in a schematic cross section of Fig. 10(d). In this way, n-type-adapted electrode 24 on the back surface of back contact solar cell 20 and n-type-adapted interconnect 12 of interconnect sheet 10 are joined, and p-type-adapted electrode 25 on the back surface of back contact solar cell 20 and p-type-adapted interconnect 13 of interconnect sheet 10 are joined, and accordingly an example of the solar cell equipped with the interconnect sheet in the second embodiment is fabricated.

Namely, as shown in Fig. 10(d), n-type-adapted electrode 24 on the back surface of back contact solar cell 20 is joined to n-type-adapted interconnect 12 mounted on the surface of insulating base material 11 of interconnect sheet 10, and p-type-adapted electrode 25 on the back surface of back contact solar cell 20 is joined to p-type-adapted interconnect 13 mounted on the surface of insulating base material 11 of interconnect sheet 10. Therefore, n-type-adapted electrode 24 of back contact solar cell 20 is electrically connected to n-type-adapted interconnect 12 of interconnect sheet 10, and p-type-adapted electrode 25 of back contact solar cell 20 is electrically connected to p-type-adapted interconnect 13 of interconnect sheet 10.

In the example of the solar cell equipped with the interconnect sheet in the second embodiment that is configured in the above-described manner, an electric current generated from the light incident on the light receiving surface of back contact solar cell 20 is drawn from n-type-adapted electrode 24 and p-type-adapted electrode 25 of back contact solar cell 20 to the outside through n-type-adapted interconnect 12 and p-type-adapted interconnect 13 of interconnect sheet 10, respectively.

Further, the solar cell equipped with the interconnect sheet in the second embodiment may be encapsulated in the above-described encapsulant.

The example of the solar cell equipped with the interconnect sheet in the second embodiment that is configured in the above-described manner can be downsized, and therefore is applicable for example to a power supply of a mobile phone.

A further description of the present embodiment, except for the one above, is similar to that of the first embodiment, and therefore, the description will not be repeated here.

### EXAMPLES

### <Example 1>

First, as the insulating base material of the interconnect sheet, a PET film of 510 mm in width, 400 mm in length, and 50 µm in thickness was prepared. Next, to the whole of one surface of the PET film, a copper foil of 35 µm in thickness was attached. An adhesive was applied to the one surface of the PET film, the copper foil was superposed thereon, and a pressure and heat were applied to attach them to each other.

Next, the copper foil on the surface of the PET film was partially etched away and patterned into the shape as shown in Fig. 1(a), so as to form interconnect 16 including comb-shaped n-type-adapted interconnect 12, comb-shaped p-type-adapted interconnect 13, and strip-shaped connection-adapted interconnect 14 electrically connecting comb-shaped n-type-adapted interconnect 12 and comb-shaped p-type-adapted interconnect 13.

Next, to the whole of the surface, on which interconnect 16 was mounted, of interconnect sheet 10, a resin composition containing an epoxy resin was applied by means of a dispenser.

Twelve back contact solar cells 20 were mounted on interconnect sheet 10, so that n-type-adapted electrode 24 of back contact solar cell 20 configured as shown in Figs. 2(a) and 2(b) was mounted on n-type-adapted interconnect 12 of interconnect sheet 10 and p-type-adapted electrode 25 of back contact solar cell 20 was mounted on p-type-adapted interconnect 13 of interconnect sheet 10.

Next, a load was applied to interconnect sheet 10 on which back contact solar cells 20 were mounted, by applying a pressure of one atmosphere from above back contact solar cells 20 toward interconnect sheet 10 while decompression was done by means of a laminator. Then, while decompression by laminator was done and the pressure of one atmosphere was applied, the resin composition was heated to 150°C to be cured, to thereby join n-type-adapted electrode 24 of back contact solar cell 20 to n-type-adapted interconnect 12 of interconnect sheet 10, and join p-type-adapted electrode 25 of back contact solar cell 20 to p-type-adapted interconnect 13 of interconnect sheet 10.

In this way, a solar cell module configured as shown in Figs. 4(a) and 4(b) was fabricated in which cured resin 17 was formed by curing resin composition 17a which was applied between semiconductor substrate 21 of back contact solar cell 20 and insulating base material 11 of interconnect sheet 10, specifically applied to the region between a comb tooth element of comb-shaped n-type-adapted electrode 24 and a comb tooth element of comb-shaped p-type-adapted electrode 25 that are adjacent to each other of back contact solar cell 20, and a region between a comb tooth element of comb-shaped n-type-adapted interconnect 12 and a comb tooth element of comb-shaped p-type-adapted interconnect 13 that are adjacent to each other on insulating base material 11.

After this, the solar cell module fabricated in the above-described manner was placed between an ethylene vinyl acetate resin (EVA resin) mounted on a glass substrate and an EVA resin mounted on a PET film. A laminator device was thereafter used to pressure-join the EVA resin on the glass substrate to back contact solar cell 20 of the solar cell module and pressure-join the EVA resin on the PET film to interconnect sheet 10 of the solar cell module. In this state, the EVA resin was heated to 125°C to be cured. Accordingly, the solar cell module of Example 1 was fabricated by encapsulating the solar cell module in the EVA resin cured between the glass substrate and the PET film.

In the solar cell module of Example 1 fabricated in the above-described manner, cured resin 17 is provided between semiconductor substrate 21 of back contact solar cell 20 and insulating base material 11 of interconnect sheet 10, specifically in the region between a comb tooth element of comb-shaped n-type-adapted electrode 24 and a comb tooth element of comb-shaped p-type-adapted electrode 25 that are adjacent to each other of back contact solar cell 20, and a region between a comb tooth element of comb-shaped n-type-adapted interconnect 12 and a comb tooth element of comb-shaped p-type-adapted interconnect 13 that are adjacent to each other on insulating base material 11. Thus, the joint between back contact solar cell 20 and insulating base material 11 of interconnect sheet 10 could further be strengthened.

Further, the solar cell module of Example 1 fabricated in the above-described manner and underwent a temperature cycle test of -40 to 85°C had no defects such as breakage of the connected parts as described above, crack of back contact solar cell 20, and peel-off of the electrodes of back contact solar cell 20. Further, a high temperature test conducted with a temperature kept at 120°C resulted in no defects such as breakage of the connected parts, crack of back contact solar cell 20, and peel-off of the electrodes of back contact solar cell 20. Here, the electrical connection could be maintained even in the ambient of 120°C.

### <Example 2>

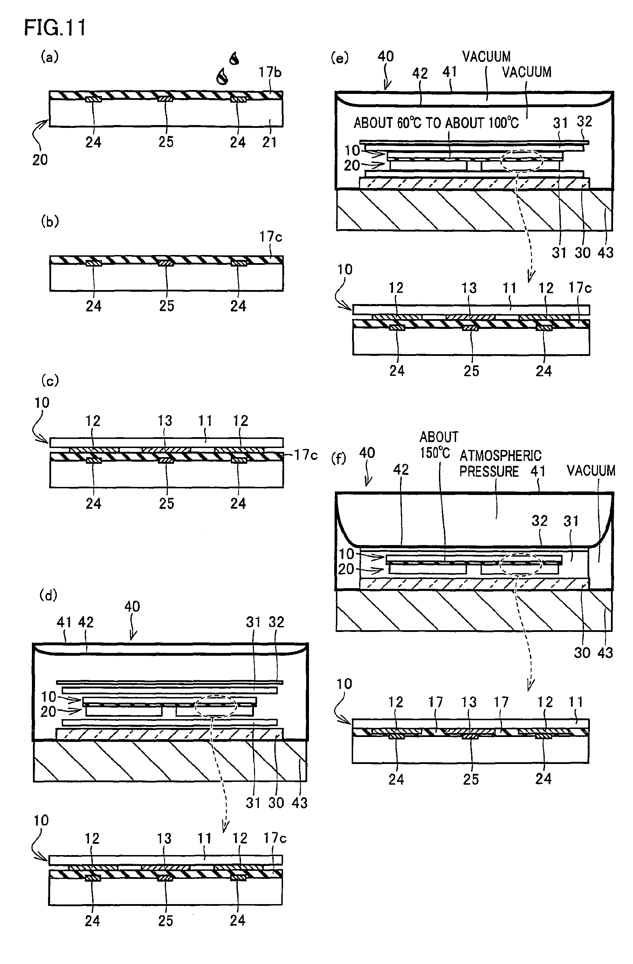

First, as shown in Fig. 11(a), to the whole of the surface, on which n-type-adapted electrode 24 and p-type-adapted electrode 25 were mounted, of back contact solar cell 20, resin composition 17b of the B stage cure (two-stage cure) type formed of a non-conductive adhesive containing an epoxy resin was applied. Here, the amount of applied resin composition 17b was only the amount that was to fill the space between back contact solar cell 20 and interconnect sheet 10, in the state where n-type-adapted electrode 24 and p-type-adapted electrode 25 of back contact solar cell 20 and n-type-adapted interconnect 12 and p-type-adapted interconnect 13 of interconnect sheet 10 were electrically connected and resin composition 17b was cured.

Next, as shown in Fig. 11(b), resin composition 17b applied onto back contact solar cell 20 was heated or subjected to light, so as to be dried and remove the solvent, and to be converted into an intermediate cure state (B stage cure state). At this time, the surface of an intermediate cure resin 17c which was generated by converting the resin composition into the B stage cure state had a low tackiness state. The tackiness is to such a degree that does not allow intermediate cure resin 17c to be bonded to back contact solar cell 20 on which the resin is merely mounted, but allows the resin to be peeled off easily without causing a crack to back contact solar cell 20.

Next, similarly to Example 1, copper attached to a PET film with an adhesive was etched and patterned to form interconnect sheet 10 which was mounted as shown in Fig. 11(c). Specifically, interconnect sheet 10 was mounted on back contact solar cell 20 so that n-type-adapted interconnect 12 of interconnect sheet 10 was located on n-type-adapted electrode 24 of back contact solar cell 20 and p-type-adapted interconnect 13 of interconnect sheet 10 was located on p-type-adapted electrode 25 of back contact solar cell 20. The intermediate cure resin 17c on back contact solar cell 20 was superposed by interconnect sheet 10 on which n-type-adapted interconnect 12 and p-type-adapted interconnect 13 were mounted.

Next, as shown in Fig. 11(d), in a chamber 41 of a laminator device 40, transparent substrate (glass substrate) 30 was mounted, encapsulant 31 formed of an ethylene vinyl acetate resin (EVA resin) was mounted thereon, and back contact solar cell 20 having interconnect sheet 10 mounted thereon in the above-described manner was mounted. Further, encapsulant 31 formed of an ethylene vinyl acetate resin (EVA resin) was mounted thereon, and protective back sheet 32 formed of a PET film was mounted thereon. At this time, a heater 43 was kept at approximately 160°C.

Next, as shown in Fig. 11(e), heater 43 was used to keep the temperature of intermediate cure resin 17c at about 60 to about 100°C, and in this state, maintain a vacuum between the top of a rubber 42 and chamber 41 and generate a vacuum in chamber 41 under rubber 42. In this way, a void (air bubble) between interconnect sheet 10 and intermediate cure resin 17c and a void between back contact solar cell 20 and intermediate cure resin 17c can be removed.

While the temperature of heater 43 was kept at approximately 160°C, the temperature of intermediate cure resin 17c was merely increased to approximately 100°C for about five minutes after mounted above heater 43, in the state where transparent substrate (glass substrate) 30, encapsulant 31 formed of an ethylene vinyl acetate resin (EVA resin), back contact solar cell 20 on which interconnect sheet 10 was mounted, encapsulant 31 formed of an ethylene vinyl acetate resin (EVA resin), and protective back sheet 32 formed of a PET film were mounted above heater 43 by being merely superposed on each other while the vacuum in the space above rubber 42 and chamber 41 was maintained.

After this, as shown in Fig. 11(f), the portion on rubber 42 in laminator device 40 was opened to the atmospheric pressure, to thereby pressure-join encapsulant 31 on transparent substrate 30 to back contact solar cell 20. Thus, in the state where encapsulant 31 on interconnect sheet 10 was pressure-joined to interconnect sheet 10, transmission of the heat of heater 43 was facilitated and accordingly the temperature of intermediate cure resin 17c was increased to approximately 150°C. Then, intermediate cure resin 17c was melt to have a temporality reduced viscosity. N-type-adapted electrode 24 and n-type-adapted interconnect 12 were pressure-joined, and p-type-adapted electrode 25 and p-type-adapted interconnect 13 were pressure-joined. The heated state thereafter continued to promote curing of intermediate cure resin 17c. At this time, curing of encapsulant 31 is also promoted. In this way, in encapsulant 31 cured between transparent substrate 30 and protective back sheet 32, back contact solar cell 20 pressure-joined to interconnect sheet 10 by cured resin 17 was encapsulated to produce a solar cell module in Example 2.

In this example, the pressure joint is performed under the conditions that the pressure is one atmosphere (atmospheric pressure) and the temperature to be reached after the start of pressure joint is 150°C. As other conditions, conditions may appropriately be set for example so that the temperature to be reached after the start of pressure joint is in a range of 130 to 180°C in a range of 1 to 10 atmospheres, for example. The viscosity of intermediate cure resin 17c before the start of pressure joint is larger than 10 Pa·s at around normal temperature and, at a temperature of 130 to 180°C which is the pressure joint temperature after the start of pressure joint, the viscosity decreases below 1 Pa·s. In this state, intermediate cure resin 17c between n-type-adapted electrode 24 of back contact solar cell 20 and n-type-adapted interconnect 12 of interconnect sheet 10 and between p-type-adapted electrode 25 of back contact solar cell 20 and p-type-adapted interconnect 13 of interconnect sheet 10 is discharged by a pressure applied at the time of pressure joint. In this way, the electrodes and the interconnects are pressure-joined and electrically connected.

The time for which pressure joint is performed is one to five minutes. In the case where pressure joint is performed for example in three minutes, the viscosity of intermediate cure resin 17c is decreased to be lower than 1 Pa·s for less than the initial two minutes of the three minutes. In the last one minute, however, the viscosity increases to become higher again than 10 Pa.s. Further, the resin cure reaction of intermediate cure resin 17c is promoted to be close to the C stage cure state (final cure state). Thus, the pressure joint between interconnect sheet 10 and back contact solar cell 20 is maintained.

Further, the solar cell module obtained in the above-described manner is heated by means of an oven or the like at 130 to 180 °C for 30 minutes to three hours, in order to improve the cure reaction percentage of cured resin 17 to 80 to 90%. Cured resin 17 has a contraction force generated by being cured, a force of tight adhesion to back contact solar cell 20, and a force of tight adhesion to interconnect sheet 10, and therefore, the pressure joint between n-type-adapted electrode 24 and p-type-adapted electrode 25 of back contact solar cell 20 and n-type-adapted interconnect 12 and p-type-adapted interconnect 13 of interconnect sheet 10 can be maintained.

The present example is characterized by that a resin composition of the B stage cure (two-stage cure) type having the above-described characteristics is used. As such a resin composition of the B stage cure type, various resin compositions may be used other than the resin composition of a nonconductive adhesive containing an epoxy resin as used in the present example. For example, BST001A (manufactured by Namics Corporation) may be used.

The solar cell module of Example 2 fabricated in the above-described manner can be produced to have the performance of the solar cell module of Example 1, and further have a feature that generation of a void between interconnect sheet 10 and back contact solar cell 20 is suppressed. Therefore, migration induced by accumulation of moisture in a void and stress concentration in the pressure-joined electrodes due to the presence of a void for example can be prevented, which improve the reliability of the solar cell module.

Further, after resin composition 17b is applied to interconnect sheet 10, it is converted into the B stage cure state to have a reduced tackiness of its surface. Therefore, even when interconnect sheet 10 and back contact solar cell 20 abut on each other, they can still be aligned to adjust the mounted positions, which improves the degree of freedom in alignment of the mounted positions.

Further, to the interconnect 16 mounted side of interconnect sheet 10, resin composition 17b of an amount is applied in advance that is only an amount to fill the space between back contact solar cell 20 and interconnect sheet 10. Therefore, the amount of resin composition 17b that spreads to the outside of the outer periphery of back contact solar cell 20 can be reduced. Further, in this case, resin composition 17b is prevented from spreading to the light receiving surface of back contact solar cell 20, so that the power generation efficiency of the solar cell module can be improved. Moreover, the amount of intermediate cure resin 17c that spreads to the outside of the outer periphery of back contact solar cell 20 can be reduced to provide a good appearance of the solar cell module.

It should be construed that embodiments and examples disclosed herein are by way of illustration in all respects, not by way of limitation. It is intended that the scope of the present invention is defined by claims, not by the description above, and encompasses all modifications and variations equivalent in meaning and scope to the claims.

### INDUSTRIAL APPLICABILITY

The present invention relates to a solar cell module and a method for manufacturing a solar cell module.

### REFERENCE SIGNS LIST

10 interconnect sheet; 11 insulating base material; 12, 12a n-type-adapted interconnect; 13, 13a p-type-adapted interconnect; 14 connection-adapted interconnect; 16 interconnect; 17 cured resin; 17a, 17b resin composition; 17c intermediate cure resin; 18 substantially orthogonal direction; 20 back contact solar cell; 21 semiconductor substrate; 22 n-type impurity diffused region; 23 p-type impurity diffused region; 24 n-type-adapted electrode; 25 p-type-adapted electrode; 26 passivation film; 27 antireflection film; 30 transparent substrate; 31 encapsulant; 31a first transparent resin; 31b second transparent resin; 32 protective back sheet; 40 laminator device; 41 chamber; 42 rubber; 43 heater

## Claims

1. A solar cell module comprising:
an interconnect sheet (10); and
a back contact solar cell (20) mounted on said interconnect sheet (10),
said interconnect sheet (10) including an insulating base material (11) and interconnects (12, 13) mounted on said insulating base material (11),
said back contact solar cell (20) including a semiconductor substrate (21) and electrodes (24, 25) formed to be connected on one surface of said semiconductor substrate (21),
said electrodes (24, 25) of said back contact solar cell (20) and said interconnects (16) of said interconnect sheet (10) being connected to each other, and
an insulating cured resin (17) being disposed in a region between said interconnects (12, 13) adjacent to each other of said interconnect sheet (10), said region being located between said semiconductor substrate (21) of said back contact solar cell (20) and said insulating base material (11) of said interconnect sheet (10).

2. The solar cell module according to claim 1, wherein
said cured resin (17) is formed by curing a resin composition (17a, 17b), and a thermal expansion force of said cured resin (17) is smaller than a contraction force of said resin composition (17a, 17b) when cured.

3. The solar cell module according to claim 2, wherein
said resin composition (17a, 17b) contains at least one of an epoxy resin and an acrylic resin.

4. The solar cell module according to claim 2, wherein
an adhesion strength of said cured resin (17) of adhering said semiconductor substrate (21) of said back contact solar cell (20) and said insulating base material (11) of said interconnect sheet (10) is larger than said contraction force of said resin composition (17a, 17b) when cured.

5. The solar cell module according to claim 4, wherein
said resin composition (17a, 17b) contains at least one of an epoxy resin and an acrylic resin.

6. The solar cell module according to claim 1, wherein
said cured resin (17) is a cured resin (17) which is cured in at least two stages.

7. The solar cell module according to claim 1, wherein
a plurality of said back contact solar cells (20) are connected to said interconnect sheet (10).

8. A method for manufacturing a solar cell module, comprising the steps of:
applying an insulating resin composition (17a, 17b) onto a surface of an interconnect sheet (10) including an insulating base material (11) and interconnects (12, 13) mounted on said insulating base material (11), said interconnects being mounted on said surface of said interconnect sheet, and/or onto one surface of a semiconductor substrate (21) of a back contact solar cell (20) including the semiconductor substrate (21) and a plurality of electrodes (24, 25) formed to be connected on said one surface, said electrodes (24, 25) being formed on said one surface;
superposing said interconnect sheet (10) and said back contact solar cell (20) on each other; and
curing said resin composition (17a, 17b) to form an insulating cured resin (17) in a region between said interconnects (12, 13) adjacent to each other of said interconnect sheet (10), said region being located between said semiconductor substrate (21) of said back contact solar cell (20) and said insulating base material (11) of said interconnect sheet (10).

9. The method for manufacturing a solar cell module according to claim 8, wherein
in said step of applying, said resin composition (17a, 17b) is applied onto the surface on which said interconnects (12, 13) of said interconnect sheet (10) are mounted, and
in said step of superposing, said back contact solar cell (20) is mounted on said interconnect sheet (10) so that said electrodes (24, 25) of said back contact solar cell (20) are located on said interconnects (12, 13) of said interconnect sheet (10).

10. The method for manufacturing a solar cell module according to claim 9, wherein
said interconnects (12, 13) of said interconnect sheet (10) include a portion shaped to have a plurality of rectangles arranged in a direction orthogonal to a longitudinal direction of the rectangles, and
in said step of applying, said resin composition (17a, 17b) is applied in a direction substantially orthogonal to said longitudinal direction of said rectangles of said interconnects (12, 13).

11. The method for manufacturing a solar cell module according to claim 9, wherein
said resin composition (17a, 17b) is converted to at least a B stage cure state and a C stage cure state.

12. The method for manufacturing a solar cell module according to claim 11, wherein
in said step of superposing, said resin composition (17a, 17b) is in said B stage cure state.

13. The method for manufacturing a solar cell module according to claim 8, wherein
in said step of applying, said resin composition (17a, 17b) is applied onto said surface on which said electrodes (24, 25) of said back contact solar cell (20) are formed, and
in said step of superposing, said interconnect sheet (10) is mounted on said back contact solar cell (20) so that said interconnects (12, 13) of said interconnect sheet (10) are located on said electrodes (24, 25) of said back contact solar cell (20).

14. The method for manufacturing a solar cell module according to claim 13, wherein
said resin composition (17a, 17b) is converted to at least a B stage cure state and a C stage cure state.

15. The method for manufacturing a solar cell module according to claim 14, wherein
in said step of superposing, said resin composition (17a, 17b) is in said B stage cure state.
